# EUROPÄISCHE PATENTSCHRIFT

(11) **EP 2 649 434 B1**
(45) Veröffentlichungstag und Bekanntmachung des Hinweises auf die Patenterteilung: **16.09.2015**
(21) Anmeldenummer: 11796628.3
(22) Anmeldetag: 09.12.2011
(51) Int. Cl.: G01N 21/956, H05K 13/08, H05K 13/04, H01L 21/67

(54) **OPTISCHE UNTERSUCHUNGSEINRICHTUNG UND OPTISCHES UNTERSUCHUNGSVERFAHREN**
OPTICAL EXAMINATION DEVICE AND OPTICAL EXAMINATION METHOD
EQUIPEMENT D'EXAMEN OPTIQUE ET PROCEDE D'EXAMEN OPTIQUE

(30) Priorität: 09.12.2010 DE 102010053912
(43) Veröffentlichungstag der Anmeldung: 16.10.2013
(73) Patentinhaber: Mühlbauer GmbH & Co. KG, 93426 Roding (DE)
(72) Erfinder: MIEHLICH, Rainer, 82024 Taufkirchen (DE); PRAKAPENKA, Uladimir, 93426 Roding (DE)
(74) Vertreter: Schmidt, Steffen
(86) Internationale Anmeldenummer: PCT/EP2011/006233
(87) Internationale Veröffentlichungsnummer: WO 2012/076189

(56) Entgegenhaltungen:
- WO-A1-2009/124817
- JP-A- 2003 008 300
- US-A- 5 991 039

## Beschreibung

### Hintergrund

Hier wird eine optische Untersuchungseinrichtung für ein Bauteil beschrieben sowie ein optisches Untersuchungsverfahren für ein Bauteil. Die Untersuchungseinrichtung hat einen ersten und einen zweiten Untersuchungsbereich.

Ein Bauteil ist hier zum Beispiel ein (elektronisches) Halbleiterbauteil, auch als "chip" oder "die" bezeichnet. Ein solches Bauteil hat einen im Wesentlichen polygonalen, zum Beispiel viereckigen (rechteckförmigen oder quadratischen) Querschnitt mit mehreren Mantelflächen sowie eine Stirnfläche und eine Deckfläche. Die Mantelflächen sowie die beiden (untere und obere) Deckflächen des Bauteils sind nachfolgend allgemein als Seitenflächen bezeichnet. Das Bauteil kann auch eine von vier abweichende Anzahl von Mantelflächen haben.

In so genannten Aufnehm- und Absetzvorrichtungen (pick und place) werden die Bauteile von einem Festhalter aufgenommen und anschließend auf einem Träger oder in einem Transportbehätter oder dergl, abgelegt. Vor dem Ablegen des Bauteils findet üblicherweise eine Inspektion des Bauteils statt. Dazu werden Abbildungen einer oder mehrerer Seitenflächen eines Bauteils mit einer Kamera aufgenommen, um eine Abbildung von Seitenflächen des Bauteils zu Überprüfungszwecken zu erzeugen.

Derartige Festhalter halten ein Bauteil während des Transports und während der Erfassung eines Bildes von einer, zum Beispiel der unteren, Deckfläche des Bauteiles fest. So zeigt die DE 10 2008 018 586 A1 eine optische Erfassungsvorrichtung für die Erfassung von einer Oberfläche eines Bauteils, das von einer ersten zu einer zweiten Arbeitsstation transportiert wird, eine auf mindestens eine erste Oberfläche des Bauteils gerichtete Kamera, eine Lichtquelle, die kurzwellige Lichtstrahlen zur ersten Oberfläche sendet. Eine zweite Lichtquelle sendet langweilige Lichtstrahlen zu mindestens einer zweiten Oberfläche des Bauteils. Die Kamera empfängt die an den Oberflächen reflektierten ersten und zweiten Lichtstrahlen. Die zweite(n) Oberfläche(n) sind gegenüber der/den ersten Oberfläche(n) unterschiedlich orientiert, wie es bei beispielsweise quaderförmigen Bauteilen mit einer Unterseite und insgesamt vier seitlichen Oberflächen der Fall ist.

Weiterer technologischer Hintergrund ist den Druckschriften WO 1995 021 376 A1, DE 199 34 619 A1, US 6 094 263 A, US 6 862 365 B1, JP 2003008300, und US 2008 0 253 643 A1 zu entnehmen.

Insebondere, WO2009/124817 offenbart eine optische Erfassungsvorrichtung und Verfahren für die Erfassung von Oberflächen von Bauteilen.

### Aufgabe

Eine optische Untersuchungseinrichtung für ein Bauteil soll unterschiedlich orientierte Seitenflächen eines Bauteiles schnell erfassen können, sowie an unterschiedliche Anforderungen einfach anzupassen sein.

### Lösung

Diese Aufgabe löst eine optische Untersuchungseinrichtung für ein Bauteil mit den Merkmalen des Anspruchs 1.

Während vorstehend ein erster und ein zweiter Untersuchungsbereich definiert sind, soll damit kein zeitlicher Ablauf oder eine Reihenfolge (zuerst eine Bilderfassung im ersten und dann eine Bilderfassung im zweiten Untersuchungsbereich) festgelegt sein. Vielmehr sind auch Fälle denkbar, in denen die umgekehrte Reihenfolge günstiger ist.

Die im ersten Untersuchungsbereich erfasste(n) Seitenfläche(n) eines Bauteils können von den im zweiten Untersuchungsbereich erfassten mehreren der Seitenflächen des Bauteils abweichen. Der erste Untersuchungsbereich und der zweite Untersuchungsbereich können entlang des Bauteilwegs um wenigstens eine halbe der Seitenlängen des zu untersuchenden Bauteils voneinander beabstandet sein. Alternativ oder ergänzend können die beiden Untersuchungsbereiche auch etwa wenigstens um die Abmessung der Kontaktstelle zwischen Bauteilförderer und zu untersuchendem Bauteil voneinander beabstandet sein. Die optische Untersuchungseinrichtung sieht vor, dass der Bauteilförderer mit einem Bauteil den Bauteilpfad vom ersten Untersuchungsbereich zum zweiten Untersuchungsbereich ohne Stillstand absolviert. Dabei werden während der Bewegung zuerst im ersten Untersuchungsbereich eine oder mehrere Seitenflächen eines Bauteils erfasst und dann im zweiten Untersuchungsbereich mehrere der Seitenflächen des Bauteils durch die bildgebende Vorrichtung optisch erfasst und anschließen mit Methoden der Bildverarbeitung ausgewertet.

Die optische Untersuchungseinrichtung sieht vor, dass die Bilderfassungeinrichtung eine Kamera aufweist, um ein Bild eines Bauteils am ersten Untersuchungsbereich getrennt von einem Bild eines Bauteils am zweiten Untersuchungsbereich zu erfassen.

Die Bilderfassungseinrichtung ist entlang eines ersten Lichtpfades auf eine Seitenfläche eines Bauteils am ersten Untersuchungsbereich gerichtet. Die Bildeinkoppeleinrichtung kann auf die Bilderfassungseinrichtung hin gerichtet, ein Bild mehrerer der Seitenflächen eines Bauteils vom zweiten Untersuchungsbereich einkoppeln. Dies erlaubt, mit einer Kamera die Bilder beider Untersuchungsbereiche zu erfassen.

Die Bilderfassungseinrichtung kann bei einer Variante der optischen Untersuchungeinrichtung auch eine erste Bildumlenkeinrichtung haben, die dazu eingerichtet ist, ein Bild mehrerer der Seitenflächen eines Bauteils zu der Bildeinkoppeleinrichtung zu lenken.

Bei einer Variante dieser optischen Untersuchungseinrichtung ist die erste Bildumlenkeinrichtung zusammen mit dem Bauteilförderer entlang des Bauteilwegs beweglich. Der Bauteilförderer hat eine Halteeinrichtung, um ein Bauteil aufzunehmen und während des Förderns entlang des Bauteilwegs zu halten. Die erste Bildumlenkeinrichtung kann zwischen zwei Positionen in Bezug auf die Halteeinrichtung hin und her bewegbar sein. In einer ersten Position ist die erste Bildumlenkeinrichtung vom Bereich der Halteeinrichtung entfernt. In einer zweiten Position ist die erste Bildumlenkeinrichtung im Bereich der Halteeinrichtung um das Erfassen eines Bildes von Seitenflächen eines Bauteils zu ermöglichen. Da die erste Bildumlenkeinrichtung von der Halteeinrichtung weg bewegbar ist, wird das Aufnehmen und/oder das Absetzen eines Bauteils durch die erste Bildumlenkeinrichtung nicht beeinträchtigt.

Die Bilderfassungseinrichtung kann im zweiten Untersuchungsbereich eine zweite Bildumlenkeinrichtung haben, die relativ zum Bauteitförderer ortsfest ist.

Sowohl die erste als auch die zweite Bildumlenkeinrichtung kann dabei einen oder mehrere Spiegel, optische Prismen, Linsen oder dergl. haben.

Die Bilderfassungseinrichtung hat im zweiten Untersuchungsbereich eine Bildfokussiereinrichtung, die ein Bild mehrerer der Seitenflächen eines Bauteils aus dem zweiten Untersuchungsbereich auf die Kamera oder die Bildeinkoppeleinrichtung hin fokussiert. Bei der Bildfokussiereinrichtung kann es sich um einen oder mehrere Spiegel, optische Prismen, Linsen öder dergl. handeln.

Die optische Untersuchungseinrichtung kann mit ersten und zweiten Lichtquellenanordnungen an beiden Untersuchungsbereichen ausgestattet sein. Dabei kann die erste Lichtquellenanordnung dazu eingerichtet sein, Licht mit einem ersten Wellenlängenbereich zur Beleuchtung zumindest eines Abschnitts des Bauteils abzugeben. Die zweite Lichtquellenanordnung kann dazu eingerichtet sein, Licht mit einem zweiten Wellenlängenbereich zur Beleuchtung zumindest eines Abschnitts des Bauteils abzugeben.

Der Wellenlängenbereich des Lichts der zweiten Lichtquellenanordnung kann vom Wellenlängenbereich des Lichts der ersten Lichtquellenanordnung zumindest teilweise abweichen. Der Wellenlängenbereich des Lichts der zweiten Lichtquellenanordnung kann aber auch mit dem Wellenlängenbereich des Lichts der ersten Lichtquellenanordnung übereinstimmen. So kann das Licht der ersten Lichtquellenanordnung rot, und das Licht der zweiten Lichtquellenanordnung kann blau sein. Es kann aber auch die umgekehrte Zuordnung oder eine andere Wellenlängenpaarung (zum Beispiel infrarotes und sichtbares Licht) gewählt sein.

Ein Variante dieser optischen Untersuchungseinrichtung sieht vor, dass die beiden Lichtquellenanordnungen durch eine Steueranordnung in dem Moment jeweils kurz eingeschaltet werden, wenn sich der Bauteilförderer mit dem Bauteil im jeweiligen ersten oder zweiten Untersuchungsbereich befindet, so dass die Seitenflächen eines Bauteils mit einem kurzen Lichtblitz belichtet werden können.

Der Bauteilförderer kann dazu eingerichtet sein, ein Bauteil mit einer Geschwindigkeit von etwa 0.1 m/s bis etwa 5 m/s entlang des Bauteilwegs zu fördern, wobei der Bauteilförderer nicht länger als 5 ms an einer Stelle verharrt. Vorzugsweise kommt der Bauteilförderer mit einem Bauteil entlang des Bauteilwegs nicht zum Stillstand, sondern bewegt sich fortwährend. In einer bevorzugten Variante ist der Bauteilförderer stets in Bewegung. Lediglich in besonderen Fällen kann es sinnvoll sein, dass der Bauteilförderer an einer Stelle anhält, um beispielsweise zwei Aufnahmen derselben Seiten mit zwei verschiedenen Beleuchtungseigenschaften zu machen. In diesem Fall kann die Verweildauer auch länger als 5 ms sein.

Ein Verfahren zur optischen Untersuchung eines Bauteils in einem ersten und in einen zweiten Untersuchungsbereich hat die Schritte des Anspruchs 9.

Die Bilderfassungseinrichtung der bildgebenden Vorrichtung ist auf eine Seitenfläche eines Bauteils am ersten Untersuchungsbereich gerichtet, und das Bild mehrerer der Seitenflächen des Bauteils wird vom zweiten Untersuchungsbereich durch eine Bildeinkoppeleinrichtung in die Bilderfassungseinrichtung eingekoppelt.

Die Bilderfassungseinrichtung erfasst ein Bild eines Bauteils am ersten Untersuchungsbereich getrennt von einem Bild eines Bauteils am zweiten Untersuchungsbereich mit einer oder mehreren Kameras.

Die Bilderfassungseinrichtung ist entlang eines ersten Lichtpfades auf eine Seitenfläche eines Bauteils am ersten Untersuchungsbereich gerichtet, und die Bildeinkoppeleinrichtung Koppelt in den ersten Lichtpfad, auf die Bilderfassungseinrichtung hin gerichtet, ein Bild mehrerer der Seitenflächen eines Bauteils vom zweiten Untersuchungsbereich ein.

Mit einer ersten Bildumlenkeinrichtung kann ein Bild mehrerer der Seitenflächen eines Bauteils zu der Bildeinkoppeleinrichtung gelenkt werden.

Die erste Bildumlenkeinrichtung kann zusammen mit dem Bauteilförderer entlang des Bauteilwegs bewegt werden.

Eine Bildfokussiereinrichtung der Bilderfassungseinrichtung im zweiten Untersuchungsbereich fokussiert ein Bild mehrerer der Seitenflächen eines Bauteils aus dem zweiten Untersuchungsbereich auf eine der Kameras oder die Kamera oder die Bildeinkoppeleinrichtung hin.

Licht mit einem ersten Wellenlängenbereich kann zur Beleuchtung zumindest eines Abschnitts des Bauteils im ersten Untersuchungsbereich abgegeben werden, und Licht mit einem zweiten Wellenlängenbereich zur Beleuchtung zumindest eines Abschnitts des Bauteils kann im zweiten Untersuchungsbereich abgegeben werden. Dabei kann der Wellenlängenbereich des Lichts der zweiten Lichtquellenanordnung vom Wellenlängenbereich des Lichts der ersten Lichtquellenanordnung zumindest teilweise abweichen, oder der Wellenlängenbereich des Lichts der zweiten Lichtquellenanordnung kann mit dem Wellenlängenbereich des Lichts der ersten Lichtquellenanordnung übereinstimmen.

Die Lichtquellenanordnung kann zwischen der Kamera und der Bildeinkoppeleinrichtung, also zum Beispiel dem Spiegel, liegen. Es ist auch möglich, die Lichtquellenanordnung direkt auf die abzubildenden Bereiche des Bauteils zu richten.

Die beiden Lichtquellenanordnungen können durch eine Steueranordnung in dem Moment jeweils kurz eingeschaltet werden, wenn sich der Bauteilförderer mit dem Bauteil längs des Bauteilwegs bewegt und sich dabei im jeweiligen ersten oder zweiten Untersuchungsbereich befindet, so dass die Seitenflächen eines Bauteils mit einem kurzen Lichtblitz belichtet werden können.

Der Bauteilförderer kann dabei ein Bauteil mit einer Geschwindigkeit von etwa 0.1 m/s bis etwa 5 m/s entlang des Bauteilwegs fördern, wobei der Bauteilförderer nicht länger als 5 ms an einer Stelle verharrt. Obwohl angestrebt ist, den Bauteilförderer entlang des Bauteilwegs gar nicht anzuhalten, kann es im Einzelfall zu einer verbesserten Bildqualität führen. In einem solchen Fall kann es angezeigt und sinnvoll sein, den Bauteilförderer entlang des Bauteilwegs anzuhalten und die Bilder des Bauteils zu erfassen.

### Kurzbeschreibung der Figuren

Weitere Merkmale, Eigenschaften, Vorteile und mögliche Abwandlungen werden für einen Fachmann anhand der nachstehenden Beschreibung deutlich, in der auf die beigefügten Zeichnungen Bezug genommen ist. Dabei zeigen die Fig. schematisch eine optische Untersuchungseinrichtung für ein Bauteil, wobei die Untersuchungseinrichtung einen ersten und einen zweiten Untersuchungsbereich hat.
- Fig. 1: zeigt schematisch einen Verfahrensschritt, mit dem in einem dem ersten Untersuchungsbereich vorgelagerten Bereich ein Bauteil von einem Substrat aufgenommen wird;
- Fig. 2: zeigt schematisch einen Verfahrensschritt, bei dem von dem in der Halteeinrichtung gehaltenen Bauteil im ersten Untersuchungsbereich ein Bild wenigstens einer der Seitenflächen mit einer bildgebenden Vorrichtung optisch erfasst wird;
- Fig. 2a: zeigt ein reales Bild eines Bauteils, wie es im ersten Untersuchungsbereich erfasst wird;
- Fig. 3: zeigt schematisch einen Verfahrensschritt, bei dem von dem in der Halteeinrichtung gehaltenen Bauteil im zweiten Untersuchungsbereich ein Bild mehrerer der Seitenflächen mit einer bildgebenden Vorrichtung optisch erfasst wird;
- Fig. 3a: zeigt ein reales Bild eines Bauteils, wie es im zweiten Untersuchungsbereich erfasst wird;
- Fig. 3b: zeigt eine schematische Draufsicht auf die Spiegel, mit denen im zweiten Untersuchungsbereich ein Bild mehrerer der Seitenflächen mit einer bildgebenden Vorrichtung optisch erfasst wird; und
- Fig. 4: zeigt schematisch einen Verfahrensschritt, bei dem das in der Halteeinrichtung gehaltene Bauteil abgelegt wird.

### Detailbeschreibung der Figuren

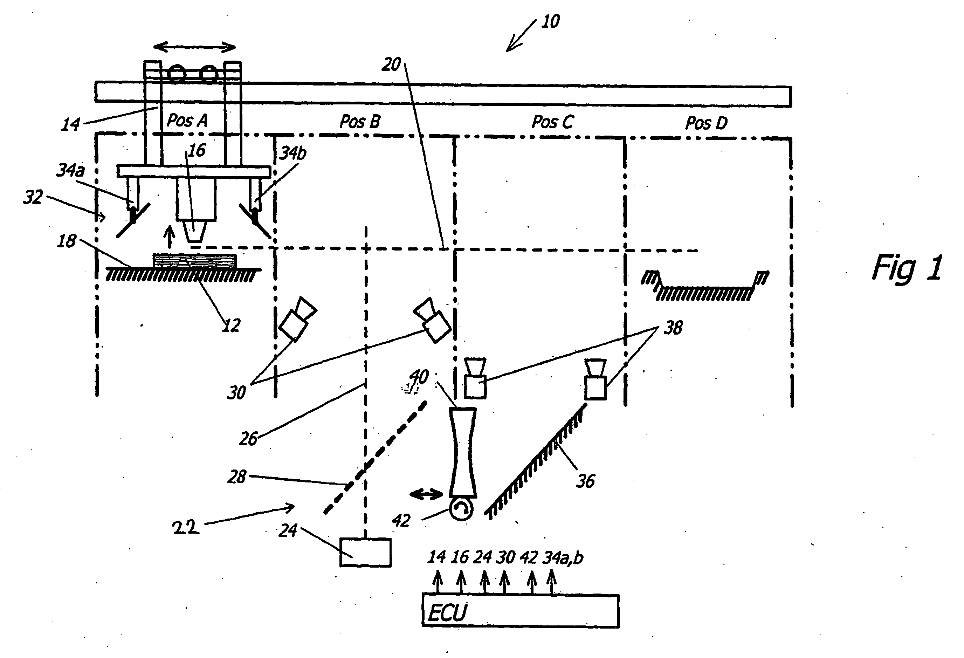

In Fig. 1 ist eine optische Untersuchungseinrichtung 10 für ein Bauteil 12 veranschaulicht. Diese optische Untersuchungseinrichtung 10 hat einen Bauteilförderer 14, der eine Halteeinrichtung 16 für das Bauteil 12 hat. In der hier veranschaulichten Variante ist die Halteeinrichtung 16 für das Bauteil 12 eine von einer Steuereinrichtung ECU gesteuerte Saugpipette. Der Bauteilförderer 14 ist dazu eingerichtet, an einer Aufnehmposition POS A mit der Saugpipette ein Bauteil 12 von einem Substrat 18 aufzunehmen, entlang eines Bauteilwegs 20 in einen ersten Untersuchungsbereich POS B, vom ersten Untersuchungsbereich POS B zu einem zweiten Untersuchungsbereich POS C, und weg vom zweiten Untersuchungsbereich POS C in einen Ablagebereich POS D zu fördern.

Um das Bauteil 12 zur optischen Untersuchung in den ersten und zweiten Untersuchungsbereich zu bringen, wird es zuerst mit der Halteeinrichtung 16 des Bauteilförderers 14 aufgenommen und entlang des Bauteilwegs 20 zum ersten Untersuchungsbereich POS B gebracht.

In Fig: 2 ist veranschaulicht, wie das Bauteil 12, während es entlang des Bauteilwegs 20 gefördert wird, im ersten Untersuchungsbereich POS B von einer bildgebenden Vorrichtung 22 optisch erfasst wird. Genauer gesagt wird im ersten Untersuchungsbereich POS B ein Bild einer der Seitenflächen - hier der unteren Deckfläche 12a - des Bauteils 12 erfasst. Die bildgebende Vorrichtung 22 hat eine Bilderfassungseinrichtung 24 mit einer Kamera, um ein Bild des Bauteils 12 am ersten Untersuchungsbereich POS B getrennt von einem Bild des Bauteils 12 am zweiten Untersuchungsbereich POS C zu erfassen. Die Bilderfassungseinrichtung 24 ist entlang eines ersten Lichtpfades 26 auf die eine Seitenfläche 12a, d.h. die untere Deckfläche des Bauteils 12 am ersten Untersuchungsbereich POS B gerichtet.

Die bildgebende Vorrichtung 22 hat eine Bildeinkoppeleinrichtung 28, die hier in Form eines dichroitischen Spiegels ausgestaltet ist. Die Bildeinkoppeleinrichtung 28 ist eingerichtet, in den ersten Lichtpfad 26, auf die Bilderfassungseinrichtung 24 hin gerichtet ein Bild mehrerer der Seitenflächen - hier der Seitenflächen 12b, 12c, 12d, 12e des Bauteils 12 - vom zweiten Untersuchungsbereich POS C einzukoppeln. Dazu ist der dichroitische Spiegel schräg (hier unter einem Winkel von etwa 45°) relativ zum ersten Lichtpfad 26 geneigt.

Der dichroitische Spiegel reflektiert nur einen Teil des Lichtspektrums und lässt den Rest des Lichtspektrums durch. Er trennt dabei das einfallende Licht nach der Wellenlänge. Der hier einzusetzende Spiegel kann dichroitisch sein; es sind aber auch andere Varianten möglich. Entscheidend ist, dass die Bildeinkoppeleinrichtung 28 nur einen Teil des Lichts durchlässt und einen Teil reflektiert. Ein dichroitischer Spiegel optimiert die Lichtausbeute um einen Faktor von etwa 2, was die Bilderfassung mit der Kamera vereinfacht.

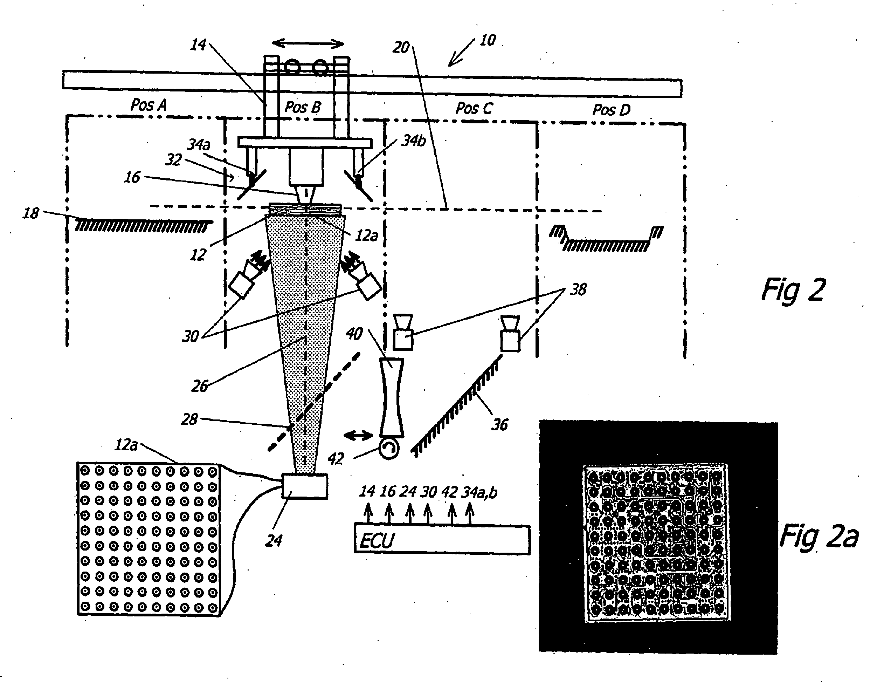

Das den ersten Untersuchungsbereich POS B entlang eines Bauteilwegs 20 passierende Bauteil 12 wird von einer ersten Lichtquellenanordnung 30 im ersten Untersuchungsbereich. POS B beleuchtet. Die erste Lichtquellenanordnung 30 bestrahlt das Bauteil 12 mit einem Lichtspektrum, das der dichroitische Spiegel entlang des ersten Lichtpfades 26 zu der Bilderfassungseinrichtung 24 durchlässt. So kann die Bilderfassungseinrichtung 24 das Bild des Bauteils 12 aufnehmen, wie es in Fig. 2 schematisch veranschaulicht ist. In Fig. 2a ist ein reales Bild der Seitenfläche - der unteren Deckfläche 12a - des Bauteils 12 gezeigt, wie es im ersten Untersuchungsbereich POS B erfasst wird.

Um das Bauteil 12 zur optischen Untersuchung von der ersten zur zweiten Untersuchungsbereich POS C zu bringen, wird es von der Halteeinrichtung 16 des Bauteilförderers . 14 entlang des Bauteilwegs 20 zum zweiten Untersuchungsbereich POS C gebracht.

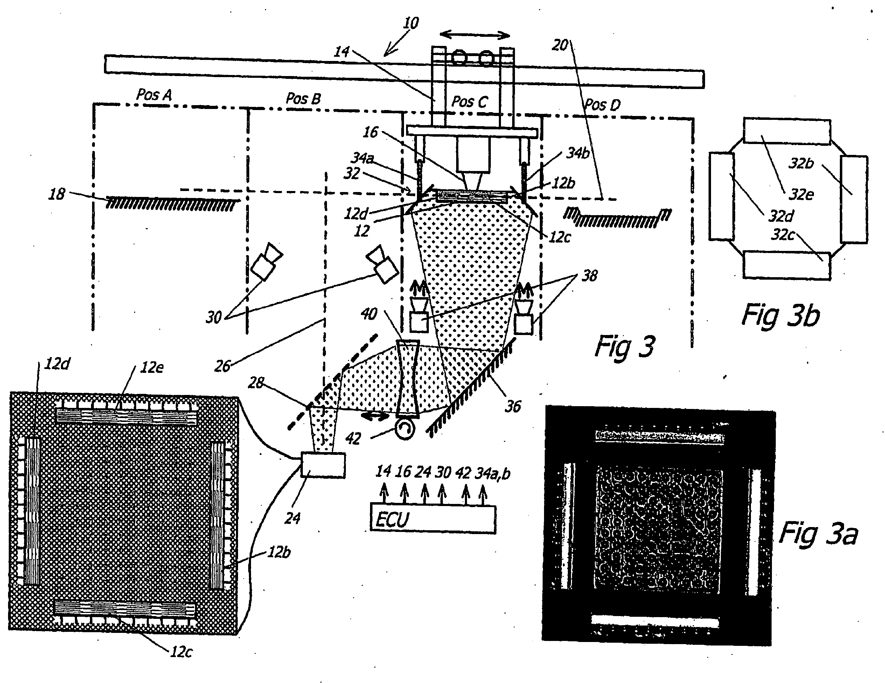

In Fig. 3 ist veranschaulicht, wie das Bauteil 12, während es entlang des Bauteilwegs 20 gefördert wird, im zweiten Untersuchungsbereich POS C von der bildgebenden Vorrichtung 22 optisch erfasst wird. Genauer gesagt wird im zweiten Untersuchungsbereich POS C ein Bild der Seitenflächen 12b, 12c, 12d, 12e des Bauteils 12 erfasst.

Im zweiten Untersuchungsbereich POS C wird das Bild des Bauteils 12 am zweiten Untersuchungsbereich POS C getrennt von dem Bild des Bauteils 12 am ersten Untersuchungsbereich POS B erfasst.

Dazu hat die Bilderfassungseinrichtung der optischen Untersuchungseinrichtung eine erste Bildumlenkeinrichtung 32, die zusammen mit dem Bauteilförderer 14 entlang des Bauteilwegs 20 beweglich ist. Die erste Bildumlenkeinrichtung 32 ist hier durch vier Spiegel 32a, 32b, 32c, 32d gebildet, welche die Halteeinrichtung 16 des Bauteilförderers 14 entlang deren Umfangs umgebend angeordnet sind. Dazu sind die vier Spiegel 32a, 32b, 32c, 32d der ersten Bildumlenkeinrichtung 32 schräg (hier unter einem Winkel von etwa 45°) zu den Seitenflächen 12b, 12c, 12d, 12e des Bauteils 12 geneigt (Siehe auch Fig. 3b). Die erste Bildumlenkeinrichtung 32 ist relativ zur Halteeinrichtung 16 des Bauteilförderers 14 zwischen einer ersten (in den Fig. oberen) und einer zweiten (in den Fig. unteren) Position verschiebbar. Dazu ist die erste Bildumlenkeinrichtung 32 über zwei Linearaktoren 34a, 34b in Längsrichtung mit dem Bauteilförderer 14 verbunden. In der ersten - zurückgezogenen - Position ist die erste Bildumlenkeinrichtung 32 von der Halteeinrichtung 16 des Bauteilförderers 14 so weit weg verschoben, dass ein Bauteil 12 in der Aufnehmposition POS A mit der Saugpipette ein Bauteil 12 von einem Substrat 18 ungehindert aufgenommen werden kann. In der zweiten - vorgeschobenen - Position ist die erste Bildumlenkeinrichtung 32 relativ zur Halteeinrichtung 16 des Bauteilförderers 14 soweit vorgeschoben, dass die (Mantel-)Seitenflächen 12b, 12c, 12d, 12e des von der Halteeinrichtung 16 gehaltenen Bauteils 12 von der ersten Bildumlenkeinrichtung 32 umgeben sind.

Im zweiten Untersuchungsbereich POS C sind zweite Lichtquellenanordnungen 38 angeordnet, die die (Mantel-)Seitenflächen 12b, 12c, 12d, 12e des von der Halteeinrichtung 16 gehaltenen Bauteils 12 mit einem Lichtspektrum beleuchten, das der dichroitische Spiegel reflektiert. Im zweiten Untersuchungsbereich Pos C befindet sich weiterhin eine relativ zum Bauteilförderer 14 ortsfeste zweite Bildumlenkeinrichtung 36 in Form eines Spiegels. Diese zweite Bildumlenkeinrichtung 36 lenkt von der ersten Bildumlenkeinrichtung 32 kommendes Licht auf den dichroitischen Spiegel der Bildeinkoppeleinrichtung 28. Der dichroitische Spiegel reflektiert das Licht entlang des ersten Lichtpfades 26 zu der Bilderfassungseinrichtung 24 hin.

Die Bilderfassungseinrichtung hat im zweiten Untersuchungsbereich POS C eine Bildfokussiereinrichtung in Form einer Linsenanordnung 40. Die Linsenanordnung 40 hat einen Stellantrieb 42 und fokussiert das von der zweiten Bildumlenkeinrichtung 36 kommende Bild mehrerer der Seitenflächen des Bauteils 12 aus dem zweiten Untersuchungsbereich POS C auf den dichroitischen Spiegel der Bildeinkoppeleinrichtung 28 bzw. die nachgeschaltete Bilderfassungseinrichtung 24 hin. Da die zweiten Lichtquellenanordnungen 38 so ausgerichtet sind, dass die (Mantel-)Seitenflächen 12b, 12c, 12d, 12e des von der Halteeinrichtung 16 gehaltenen Bauteils 12 beleuchtet sind, wird die untere Deckfläche 12a des Bauteils 12 im zweiten Untersuchungsbereich POS C praktisch nicht erfasst. Dies ist auch in der Fig. 3a zu sehen, die ein reales Bild der (Mantel-)Seitenflächen 12b, 12c, 12d, 12e des von der Halteeinrichtung 16 gehaltenen Bauteils 12 zeigt, wie es im zweiten Untersuchungsbereich POS C erfasst wird.

Die beiden Lichtquellenanordnungen werden durch eine Steueranordnung ECU in dem Moment jeweils kurz eingeschaltet, wenn sich der Bauteilförderer mit dem Bauteil 12 im jeweiligen ersten bzw. zweiten Untersuchungsbereich befindet. Dazu können nicht weiter veranschaulichte Positionssensoren an den beiden Untersuchungsbereichen befinden. Alternativ dazu kann die Steueranordnung ECU, die auch mit dem Antrieb des Bauteilförderers gekoppelt ist, dessen Antriebssignale auswerten um festzustellen, wenn sich der Bauteilförderer in den passenden Positionen in den beiden Untersuchungsbereichen befindet, um die Seitenflächen eines Bauteils mit einem kurzen Lichtblitz zu belichten.

Als Lichtspektrum stahlt in dieser Anordnung die erste Lichtquellenanordnung ein rotes Licht, und die zweite Lichtquellenanordnung ein blaues Licht aus.

Der Bauteilförderer 14 transportiert die Bauteile 12 zum Beispiel mit einer Geschwindigkeit von etwa 1,5 - 2 m/s (zum Beispiel etwa 1,75 m/s), ohne dabei von der POS A (nach dem Aufnehmen) bis zur POS D (vor dem Ablegen) anzuhalten. Durch die kompakte Gesamtanordnung können die ersten und zweiten Untersuchungsbereiche sehr dicht beieinander liegen (ca. 20 mm bis 50 mm, zum Beispiel 35 mm zwischen der Position der Aufnahme des ersten Bildes und der Position der Aufnahme des zweiten Bildes). Somit steuert die Steueranordnung ECU die zweite Lichtquellenanordnung etwa 20 ms nach der ersten Lichtquellenanordnung an. So erlaubt die vorliegende Anordnung ein optimales Auslegen des Sehfeldes für die jeweilige Gegebenheit der Bilderfassung. Dazu kann im ersten Untersuchungsbereich die in der Regel kritischer zu beurteilende untere Seitenfläche des Bauteils größer dargestellt werden als die im zweiten Untersuchungsbereich zu erfassenden (Mantel-)Seitenflächen. Insgesamt ist im ersten Untersuchungsbereich POS B die Bilderfassung optimal an die untere Seitenfläche des Bauteils angepasst und im zweiten Untersuchungsbereich POS C die Bilderfassung optimal an die (Mantel-)Seitenflächen des Bauteils angepasst. Da der Bauteilförderer 14 die Bauteile 12 entlang des Bauteilpfades 20 ohne anzuhalten transportieren kann, während die Bilderfassung in den beiden Untersuchungsbereichen stattfindet, kann der Durchsatz gegenüber herkömmlichen Anordnungen erheblich gesteigert werden.

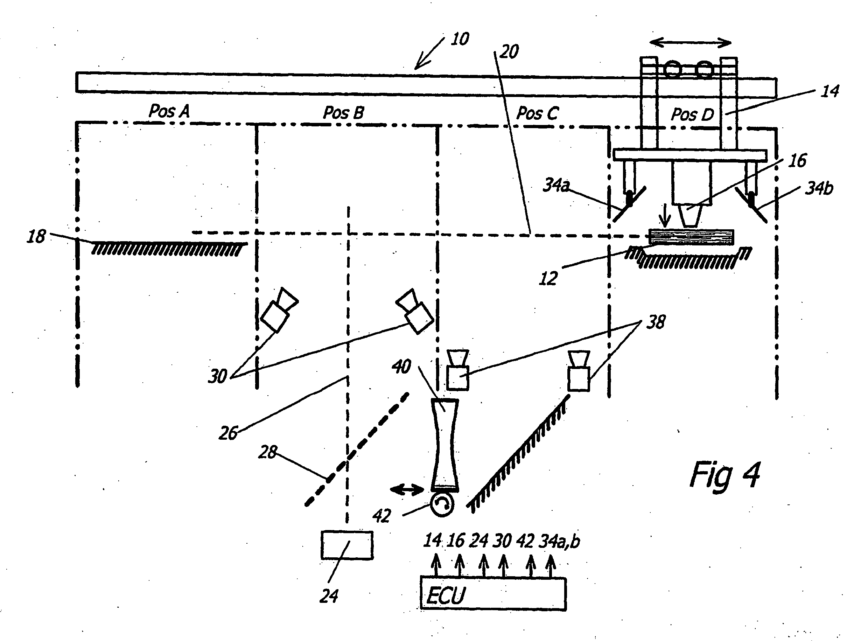

In Fig. 4 ist veranschaulicht, wie das Bauteil 12 am Ende des Bauteilwegs 20 im Ablagebereich POS D in einem sog. Indexer abgelegt wird. Dazu wird, während des Transports zu dem Ablagebereich POS D, die erste Bildumlenkeinrichtung 32 von der Halteeinrichtung 16 des Bauteilförderers 14 so weit weg in die erste - zurückgezogene - Position verschoben, dass ein Bauteil 12 ungehindert von der Saugpipette in den Indexer abgelegt werden kann.

## Patentansprüche

1. Optische Untersuchungseinrichtung für ein Bauteil (12), die einen ersten und einen zweiten Untersuchungsbereich (POS B, POS C) hat, mit
• einer bildgebenden Vorrichtung (22) zum optischen Erfassen von Seitenflächen (12a, 12b, 12c, 12d, 12e) eines Bauteils (12), wobei die bildgebende Vorrichtung (22) dazu eingerichtet ist,
∘ im ersten Untersuchungsbereich (POS B) ein Bild einer der Seitenflächen des Bauteils (12) zu erfassen und
∘ im zweiten Untersuchungsbereich (POS C) ein Bild mehrerer der Seitenflächen des Bauteils (12) zu erfassen;
• einem Bauteilförderer (14), der
∘ eine Halteeinrichtung für das Bauteil (12) hat, und der
∘ dazu eingerichtet ist, das gehaltene Bauteil (12) entlang eines Bauteilwegs (20) zum ersten und zum zweiten Untersuchungsbereich zu fördern; wobei
• die bildgebende Vorrichtung (22)
∘ eine Bilderfassungseinrichtung (24), die eine Kamera aufweist und dazu eingerichtet ist, auf eine Seitenfläche (12a) des Bauteils (12) am ersten Untersuchungsbereich (POS B) gerichtet zu werden, und
∘ eine Bildeinkoppeleinrichtung (28), die dazu eingerichtet ist, in die Bilderfassungseinrichtung (24) ein Bild mehrerer der Seitenflächen (12b, 12c, 12d, 12e) des Bauteils (12) vom zweiten Untersuchungsbereich (POS C) einzukoppeln aufweist, und ferner
∘ eine Bildfokussiereinrichtung (40) aufweist, die ein Bild mehrerer der Seitenflächen (12b, 12c, 12d, 12e) des Bauteils (12) aus dem zweiten Untersuchungsbereich (POS C) auf die Kamera (24) oder die Bildeinkoppeleinrichtung (28) hin fokussiert, wobei
der Bauteilförderer (14) dazu eingerichtet ist, das Bauteil kontinuierlich entlang des Bauteilwegs (20) zu fördern, und wobei die Bilderfassungseinrichtung (24) die Kamera aufweist, um das Bild des Bauteils (12) am ersten Untersuchungsbereich (POS B) getrennt vom Bild des Bauteils (12) am zweiten Untersuchungsbereich (POS C) zu erfassen, und wobei die Bilderfassungseinrichtung (24) dazu eingerichtet ist, entlang eines ersten Lichtpfades (26) auf eine Seitenfläche (12a) des Bauteils (12) am ersten Untersuchungsbereich (POS B) gerichtet zu werden, und die Bildeinkoppeleinrichtung (28) dazu eingerichtet ist, in den ersten Lichtpfad (26), auf die Bilderfassungseinrichtung (24) hin gerichtet, das Bild mehrerer der Seitenflächen (12b, 12c, 12d, 12e) des Bauteils (12) am zweiten Untersuchungsbereich (POS C) einzukoppeln.

2. Optische Untersuchungseinrichtung nach dem vorhergehenden Anspruch, wobei die bildgebende Vorrichtung (22) eine erste Bildumlenkeinrichtung (32) aufweist, die dazu eingerichtet ist, ein Bild mehrerer der Seitenflächen (12b, 12c, 12d, 12e) des Bauteils (12) zu der Bildeinkoppeleinrichtung (28) zu lenken.

3. Optische Untersuchungseinrichtung nach dem vorhergehenden Anspruch, wobei die erste Bildumlenkeinrichtung (32) zusammen mit dem Bauteilförderer (14) entlang des Bauteilwegs (20) beweglich ist, wobei der Bauteilweg (20) sich wenigstens zum ersten Untersuchungsbereich (POS B), vom ersten Untersuchungsbereich (POS B) zum zweiten Untersuchungsbereich (POS C) und weg vom zweiten Untersuchungsbereich (POS C) erstreckt.

4. Optische Untersuchungseinrichtung nach einem der vorhergehenden Ansprüche, wobei die bildgebende Vorrichtung im zweiten Untersuchungsbereich (POS C) eine zweite, ortsfeste Bildumlenkeinrichtung (36) aufweist, relativ zu der der Bauteilförderer (14) beweglich ist.

5. Optische Untersuchungseinrichtung nach dem vorhergehenden Anspruch, wobei die Bildfokussiereinrichtung (40) eine Linsenanordnung mit einem Stellantrieb (42) aufweist, die das von der zweiten Bildumlenkeinrichtung (36) kommende Bild aus dem zweiten Untersuchungsbereich (POS C) auf die Kamera (24) oder die Bildeinkoppeleinrichtung (28) hin fokussiert.

6. Optische Untersuchungseinrichtung nach einem der vorhergehenden Ansprüche, mit jeweiligen ersten und zweiten Lichtquellenanordnungen (30, 38) an dem jeweiligen der ersten und zweiten Untersuchungsbereiche (POS B, POS C), wobei
• die erste Lichtquellenanordnung (30) dazu eingerichtet ist, Licht mit einem ersten Wellenlängenbereich zur Beleuchtung zumindest eines Abschnitts des Bauteils (12) abzugeben und
• die zweite Lichtquellenanordnung (38) dazu eingerichtet ist, Licht mit einem zweiten Wellenlängenbereich zur Beleuchtung zumindest eines Abschnitts des Bauteils (12) abzugeben.

7. Optische Untersuchungseinrichtung nach Anspruch 6, wobei der Wellenlängenbereich des Lichts der zweiten Lichtquellenanordnung (38) vom Wellenlängenbereich des Lichts der ersten Lichtquellenanordnung (30) zumindest teilweise abweicht, oder wobei der Wellenlängenbereich des Lichts der zweiten Lichtquellenanordnung (38) mit dem Wellenlängenbereich des Lichts der ersten Lichtquellenanordnung (30) übereinstimmt.

8. Optische Untersuchungseinrichtung nach Anspruch 6 oder 7, wobei die beiden Lichtquellenanordnungen durch eine Steueranordnung (ECU) in dem Moment jeweils kurz eingeschaltet werden, wenn sich der Bauteilförderer (14) mit dem Bauteil (12) im jeweiligen ersten oder zweiten Untersuchungsbereich (POS B, POS C) befindet, so dass die Seitenflächen des Bauteils mit einem kurzen Lichtblitz belichtet werden können.

9. Verfahren zur optischen Untersuchung eines Bauteils in einem ersten und in einem zweiten Untersuchungsbereich, mit den Schritten
∘ Aufnehmen eines Bauteils mit einer Halteeinrichtung eines Bauteilförderers;
∘ Fördern des in der Halteeinrichtung gehaltenen Bauteils entlang eines Bauteilwegs zum ersten Untersuchungsbereich;
∘ optisches Erfassen eines Bilds wenigstens einer der Seitenflächen des Bauteils mit einer bildgebenden Vorrichtung im ersten Untersuchungsbereich;
∘ Fördern des in der Halteeinrichtung gehaltenen Bauteils entlang des Bauteilwegs vom ersten Untersuchungsbereich zum zweiten Untersuchungsbereich;
∘ optisches Erfassen eines Bilds mehrerer der Seitenflächen des Bauteils mit einer bildgebenden Vorrichtung im zweiten Untersuchungsbereich; wobei der Bauteilförderer das Bauteil kontinuierlich entlang des Bauteilwegs fördert, und wobei eine Bilderfassungseinrichtung entlang eines ersten Lichtpfads auf eine Seitenfläche des Bauteils im ersten Untersuchungsbereich gerichtet wird, und eine Bildeinkoppeleinrichtung in den ersten Lichtpfad, auf die Bilderfassungseinrichtung hin gerichtet, das Bild mehrerer der Seitenflächen des Bauteils im zweiten Untersuchungsbereich einkoppelt, und Fokussieren des Bildes mehrerer der Seitenflächen des Bauteils aus dem zweiten Untersuchungsbereich auf eine Kamera oder die Bildeinkoppeleinrichtung hin mittels einer Bildfokussiereinrichtung der bildgebenden Vorrichtung oder der Bilderfassungseinrichtung im zweiten Untersuchungsbereich; wobei die Bilderfassungseinrichtung das Bild des Bauteils am ersten Untersuchungsbereich getrennt vom Bild des Bauteils am zweiten Untersuchungsbereich mit der Kamera erfasst.

10. Verfahren nach Anspruch 9, wobei mit einer ersten Bildumlenkeinrichtung das Bild mehrerer der Seitenflächen des Bauteils zu der Bildeinkoppeleinrichtung gelenkt wird.

11. Verfahren nach Anspruch 10, wobei die erste Bildumlenkeinrichtung zusammen mit dem Bauteilförderer entlang des Bauteilwegs bewegt wird.

12. Verfahren nach einem der Ansprüche 9 bis 11, wobei die Bildfokussiereinrichtung eine Linsenanordnung mit einem Stellantrieb aufweist und das Bild mehrerer der Seitenflächen des Bauteils aus dem zweiten Untersuchungsbereich auf die Kamera oder die Bildeinkoppeleinrichtung hin fokussiert.

13. Verfahren nach einem der Ansprüche 9 bis 12, wobei mittels einer ersten Lichtquellenanordnung Licht mit einem ersten Wellenlängenbereich zur Beleuchtung zumindest eines Abschnitts des Bauteils im ersten Untersuchungsbereich abgegeben wird und mittels einer zweiten Lichtquellenanordnung Licht mit einem zweiten Wellenlängenbereich zur Beleuchtung zumindest eines Abschnitts des Bauteils im zweiten Untersuchungsbereich abgegeben wird, und wobei der Wellenlängenbereich des Lichts der zweiten Lichtquellenanordnung vom Wellenlängenbereich des Lichts der ersten Lichtquellenanordnung zumindest teilweise abweicht oder der Wellenlängenbereich des Lichts der zweiten Lichtquellenanordnung mit dem Wellenlängenbereich des Lichts der ersten Lichtquellenanordnung übereinstimmt.

14. Verfahren nach Anspruch 13, wobei die beiden Lichtquellenanordnungen durch eine Steueranordnung in dem Moment jeweils kurz eingeschaltet werden, wenn sich der Bauteilförderer mit dem Bauteil im jeweiligen ersten oder zweiten Untersuchungsbereich befindet, so dass die Seitenflächen des Bauteils mit einem kurzen Lichtblitz belichtet werden können.

15. Verfahren nach einem der Ansprüche 9 bis 14, wobei der Bauteilförderers das Bauteil mit einer Geschwindigkeit von etwa 0.1 m/s bis etwa 5 m/s entlang des Bauteilwegs fördert.

## Claims

1. Optical examination device for a component (12) having a first and second examination region (POS B, POS C), having
• an imaging device (22) for optically acquiring lateral surfaces (12a, 12b, 12c, 12d, 12e) of a component (12), wherein the imaging device (22) is configured to
∘ to acquire an image of one of the lateral surfaces of the component (12) in the first examination region (POS B) and
∘ to acquire an image of a plurality of the lateral surfaces of the component (12) in the second examination region (POS C);
• a component conveyor (14), which
∘ has a holding device for the component (12), and which
∘ is configured to convey the held component (12) along a component path (20) to the first and to the second examination region; wherein
• the imaging device (22) having
∘ an image acquisition device (24), having a camera and which is configured to be pointed at a lateral surface (12a) of the component (12) in the first examination region (POS B), and
∘ an image directing device (28), which is configured to direct an image of a plurality of the lateral surfaces (12b, 12c, 12d, 12e) of the component (12) from the second examination region (POS C) into the image acquisition device (24) and
∘ an imaging focusing device (40), which focuses an image of a plurality of the lateral surfaces (12b, 12c, 12d, 12e) of the component (12) from the second examination region (POS C) onto the camera (24) or the image directing device (28), and
the component conveyor (14) is configured to continuously convey the component along the component path (20), and wherein the image acquisition device (24) comprises the camera in order to acquire the image of the component (12) in the first examination region (POS B) separately from the image of the component (12) in the second examination region (POS C), and wherein the image acquisition device (24) is configured to be pointed along a first light path (26) at a lateral surface (12a) of the component (12) in the first examination region (POS B), and the image directing device (28) is configured to direct an image of a plurality of the lateral surfaces (12b, 12c, 12d, 12e) of the component (12) in the second examination region (POS C) into the first light path (26), directed towards the image acquisition device (24).

2. Optical examination device according to the preceding claim, wherein the imaging device (22) comprises a first image deflection device (32), which is configured to deflect an image of a plurality of the lateral surfaces (12b, 12c, 12d, 12e) to the image directing device (28).

3. Optical examination device according to the preceding claim, wherein the first image deflection device (32) together with the component conveyor (14) is movable along the component path (20), wherein the component path (20) extends at least to the first examination region (POS B), from the first examination region (POS B) to the second examination region (POS C), and away from the second examination region (POS C).

4. Optical examination device according to one of the preceding claims, wherein the imaging device comprises, in the second examination region (POS C), a second, stationary image deflection device (36), relative to which the component conveyor (14) is movable.

5. Optical examination device according to the preceding claim, wherein the image focusing device (40) comprises a lens arrangement with an actuating drive (42), which focuses the image coming from the second image deflection device (36) from the second examination region (POS C) onto the camera (24) or the image directing device (28).

6. Optical examination device according to one of the preceding claims, having respective first and second light source arrangements (30, 38) in the respective first and second examination regions (POS B, POS C), wherein
• the first light source arrangement (30) is configured to emit light having a first wavelength range for illuminating at least one section of the component (12) and
• the second light source arrangement (38) is configured to emit light having a second wavelength range for illuminating of at least one section of the component (12).

7. Optical examination device according to claim 6, wherein the wavelength range of the light of the second light source arrangement (38) at least partially differs from the wavelength range of the light of the first light source arrangement (30), or wherein the wavelength range of the light of the second light source arrangement (38) corresponds with the wavelength range of the light of the first light source arrangement (30).

8. Optical examination device according to claim 6 or 7, wherein the two light source arrangements are each switched on briefly by a control device (ECU) at the moment when the component conveyor (14) with the component (12) is situated in the respective first or second examination region (POB, POS C), so that the lateral surfaces of the component can be exposed to a short flash of light.

9. Method for optically examining of a component in a first and in a second examination region, having the steps of
∘ picking up a component with a holding device of a component conveyor;
∘ conveying of one of the components held in the holding device along a component path to the first examination region;
∘ optically acquiring an image of at least one of the lateral surfaces of the component with an imaging device in the first examination region;
∘ conveying of one of the components held in the holding device along the component path from the first examination region to the second examination region;
∘ optically acquiring an image of a plurality of the lateral surfaces of the component with an imaging device in the second examination region; wherein the component conveyor continuously conveys the component along the component path, wherein the image acquisition device is pointed along a first light path at a lateral surface of the component in the first examination region, and the image directing device directs an image of a plurality of the lateral surfaces of the component in the second examination region into the first light path, directed towards the image acquisition device, and focusing an image of a plurality of the lateral surfaces of the component from the second examination region onto the camera or image directing device by means of an image focusing device of the imaging device or of the image acquisition device in the second examination region; wherein the image acquisition device acquires an image of the component in the first examination region separately from the image of a component in the second examination region with a camera.

10. Method according to claim 9, wherein an image of a plurality of the lateral surfaces of a component is deflected to the image directing device with a first image deflection device.

11. Method according to claim 10, wherein the first image deflection device is moved together with the component conveyor along the component path.

12. Method according to one of claims 9 to 11, wherein the image focusing device, comprising a lens arrangement with an actuating drive, focuses the image of a plurality of the lateral surfaces of the component in the second examination region onto the camera or the image directing device.

13. Method according to one of claims 9 to 12, wherein light with a first wavelength range is emitted by means of a first light source arrangement for illuminating of at least one section of the component in the first examination region and light with a second wavelength range is emitted by means of a second light source arrangement for illuminating at least one section of the component in the second examination region, and wherein the wavelength range of the light of the second light source arrangement differs at least partially from the wavelength range of the light of the first light source arrangement, or the wavelength range of the light of the second light source arrangement corresponds with the wavelength range of the light of the first light source arrangement.

14. Method according to claim 13, wherein the two light source arrangements are each switched on briefly by a control arrangement at the moment when the component conveyor with the component is situated in the respective first or second examination region, so that the lateral surfaces of the component can be exposed to a short flash of light.

15. Method according to one of claims 9 to 14, wherein the component conveyor conveys the component along the component path with a speed of approximately 0.1 m/s to approximately 5 m/s.

## Revendications

1. Equipement d'examen optique pour une pièce (12), présentant une première et une deuxième zone d'examen (POS B, POS C) et comprenant
▪ un dispositif d'imagerie (22) pour l'acquisition optique de faces latérales (12a, 12b, 12c, 12d, 12e) d'une pièce (12), ledit dispositif d'imagerie (22) étant conçu
∘ pour acquérir dans la première zone d'examen (POS B) une image d'une des faces latérales de la pièce (12) et
∘ dans la deuxième zone d'examen (POS C) une image de plusieurs des faces latérales de la pièce (12) ;
▪ un convoyeur de pièce (14) qui
∘ est pourvu d'un dispositif de maintien (14) pour le maintien de la pièce (12) et
∘ est conçu pour déplacer la pièce (12) maintenue suivant une trajectoire de pièce (20) vers la première et la deuxième zone d'examen ;
▪ le dispositif d'imagerie (22) présentant
∘ un dispositif d'acquisition d'image (24) qui présente une caméra et qui est conçu pour être dirigé vers une face latérale (12a) de la pièce (12) dans la première zone d'examen (POS B),
∘ un dispositif de couplage d'image (28) qui est conçu pour coupler en entrée dans le dispositif d'acquisition d'image (24) une image de plusieurs des faces latérales (12b, 12c, 12d, 12e) de la pièce (12) dans la deuxième zone d'examen (POS C), ainsi que
∘ un dispositif de focalisation d'image (40) qui focalise vers la caméra (24) ou le dispositif d'injection d'image (28) une image de plusieurs des faces latérales (12b, 12c, 12d, 12e) de la pièce (12) dans la deuxième zone d'examen (POS C),
le convoyeur de pièce (14) étant conçu pour déplacer de manière continue la pièce (12) suivant la trajectoire de pièce (20), et le dispositif d'acquisition d'image (24) pourvu de la caméra pour acquérir l'image de la pièce (12) dans la première zone d'examen (POS B) indépendamment de l'image de la pièce (12) dans la deuxième zone d'examen (POS C), et le dispositif d'acquisition d'image (24) étant conçu pour être dirigé suivant un premier chemin lumineux (26) sur une face latérale (12a) de la pièce (12) dans la première zone d'examen (POS B), et le dispositif de couplage d'image (28) pour coupler en entrée dans le premier chemin lumineux (26) l'image de plusieurs des faces latérales (12b, 12c, 12d, 12e) de la pièce (12) dans la deuxième zone d'examen (POS C).

2. Equipement d'examen optique selon la revendication précédente, le dispositif d'imagerie (22) présentant un premier dispositif de renvoi d'image (32) qui est conçu pour diriger une image de plusieurs des faces latérales (12b, 12c, 12d, 12e) de la pièce (12) vers le dispositif de couplage d'image (28).

3. Equipement d'examen optique selon la revendication précédente, ledit premier dispositif de renvoi d'image (32) se déplaçant conjointement avec le convoyeur de pièce (14) suivant la trajectoire de pièce (20), cette trajectoire s'étendant au moins jusqu'à la première zone d'examen (POS B), de la première zone d'examen (POS B) à la deuxième zone d'examen (POS C) et s'éloignant de la deuxième zone d'examen (POS C).

4. Equipement d'examen optique selon l'une des revendications précédentes, le dispositif d'imagerie présentant dans la deuxième zone d'examen (POS C) un deuxième dispositif de renvoi d'image (36) stationnaire par rapport auquel se déplace le convoyeur de pièce (14).

5. Equipement d'examen optique selon la revendication précédente, le dispositif de focalisation d'image (40) présentant un agencement de lentilles doté d'un mécanisme de commande (42), lequel agencement focalise vers la caméra (24) ou ou le dispositif de couplage d'image (28) l'image venant du deuxième dispositif de renvoi d'image (36) dans la deuxième zone d'examen (POS C).

6. Equipement d'examen optique selon l'une des revendications précédentes, comprenant respectivement un premier et un deuxième agencement formant source lumineuse (30, 38) dans la première et la deuxième zone d'examen (POS B, POS C),
• le premier agencement formant source lumineuse (30) étant conçu pour émettre de la lumière dans une première plage de longueurs d'ondes pour éclairer au moins une partie de la pièce (12), et
• le deuxième agencement formant source lumineuse (38) étant conçu pour émettre de la lumière dans une deuxième plage de longueurs d'ondes pour éclairer au moins une partie de la pièce (12).

7. Equipement d'examen optique selon la revendication 6, la plage de longueurs d'ondes de la lumière du deuxième agencement formant source lumineuse (38) différant au moins partiellement de la plage de longueurs d'ondes de la lumière du premier agencement formant source lumineuse (30), ou la plage de longueurs d'ondes de la lumière du deuxième agencement formant source lumineuse (38) correspondant à la plage de longueurs d'ondes de la lumière du premier agencement formant source lumineuse (30).

8. Equipement d'examen optique selon la revendication 6 ou 7, les deux agencements formant source lumineuse (38) étant respectivement brièvement allumés par le biais d'une unité de commande (ECU) au moment où le convoyeur de pièce (14) se trouve dans la première ou la deuxième zone d'examen (POS B, POS C) de sorte que les faces latérales de la pièce peuvent être exposées à un court flash de lumière.

9. Procédé pour l'examen optique d'une pièce dans une première et une deuxième zone d'examen, comportant les étapes suivantes :
∘ la réception d'une pièce par un dispositif de maintien d'un convoyeur de pièce ;
∘ le déplacement de la pièce maintenue dans le dispositif de maintien suivant une trajectoire de pièce vers la première zone d'examen ;
∘ l'acquisition optique d'une image d'au moins une des faces latérales de la pièce a l'aide d'un dispositif d'imagerie dans la première zone d'examen ;
∘ le déplacement de la pièce maintenue dans le dispositif de maintien suivant la trajectoire de pièce de la première zone d'examen à la deuxième zone d'examen ;
∘ l'acquisition optique d'une image de plusieurs des faces latérales de la pièce à l'aide d'un dispositif d'imagerie dans la deuxième zone d'examen ;
le convoyeur de pièce déplaçant de manière continue la pièce suivant la trajectoire de pièce, et un dispositif d'acquisition d'image étant dirigé suivant un premier chemin lumineux sur une face latérale de la pièce dans la première zone d'examen, et un dispositif de couplage dirigé vers le dispositif d'acquisition d'image couplant en entrée dans le premier chemin lumineux l'image de plusieurs des faces latérales de la pièce dans la deuxième zone d'examen, et l'image de plusieurs des faces latérales de la pièce étant focalisée vers une caméra ou le dispositif de couplage d'image à l'aide d'un dispositif de focalisation d'image du dispositif d'imagerie ou du dispositif d'acquisition d'image dans la deuxième zone d'examen, le dispositif d'acquisition acquérant à l'aide de la caméra l'image de la pièce dans la première zone d'examen séparément de l'image de la pièce dans la deuxième zone d'examen.

10. Procédé selon la revendication 9, l'image de plusieurs des faces latérales de la pièce étant dirigée vers le dispositif de couplage d'image à l'aide d'un premier dispositif de renvoi d'image.

11. Procédé selon la revendication 10, le premier dispositif de renvoi d'image étant déplacé conjointement avec le convoyeur de pièce suivant la trajectoire de pièce.

12. Procédé selon l'une des revendications 9 à 11, le dispositif de focalisation d'image, qui présente un agencement de lentilles pourvu d'un mécanisme de commande, focalisant vers la caméra ou le dispositif de couplage d'image l'image de plusieurs des faces latérales de la pièce prise dans la deuxième zone d'examen.

13. Procédé selon l'une des revendications 9 à 12, de la lumière état émise dans une première plage de longueurs d'ondes à l'aide d'un premier agencement formant source lumineuse pour éclairer au moins une partie de la pièce dans la première zone d'examen, et de la lumière étant émise dans une deuxième plage de longueurs d'ondes à l'aide d'un deuxième agencement formant source lumineuse pour éclairer au moins une partie de la pièce dans la première zone d'examen, et la plage de longueurs d'ondes de la lumière du deuxième agencement formant source lumineuse différant au moins partiellement de la plage de longueurs d'ondes de la lumière du premier agencement formant source lumineuse, ou la plage de longueurs d'ondes de la lumière du deuxième agencement formant source lumineuse correspondant à la plage de longueurs d'ondes de la lumière du premier agencement formant source lumineuse.

14. Procédé selon la revendication 13, les deux agencements formant source lumineuse étant respectivement brièvement allumés par le biais d'une unité de commande (ECU) au moment où le convoyeur de pièce (14) se trouve dans la première ou la deuxième zone d'examen (POS B, POS C) de sorte que les faces latérales de la pièce peuvent être exposées à un court flash de lumière.

15. Procédé selon l'une des revendications 9 à 14, le convoyeur de pièce déplaçant la pièce à une vitesse comprise entre environ 0,1 m/s et environ 5 m/s suivant la trajectoire de pièce.
